# EUROPEAN PATENT SPECIFICATION

(11) **EP 3 795 271 B1**
(45) Date of publication and mention of the grant of the patent: **24.05.2023**
(21) Application number: 18918593.7
(22) Date of filing: 14.05.2018
(51) Int. Cl.: H05K 13/04, H05K 13/08, H05K 13/00, B21F 11/00, B23D 17/00, B23Q 17/22, B23Q 17/24

(54) **MOUNTER PROVIDED WITH A LEAD WIRE CUTTING UNIT**
MONTAGEVORRICHTUNG MIT EINER ANSCHLUSSDRAHTSCHNEIDEEINHEIT
DISPOSITIF DE MONTAGE AVEC UNE UNITÉ DE COUPE DE FIL CONDUCTEUR

(43) Date of publication of application: 24.03.2021
(73) Proprietor: FUJI Corporation, Chiryu-shi, Aichi 472-8686 (JP)
(72) Inventor: CHI, Xiaodong, Chiryu-shi, Aichi 472-8686 (JP); NONOMURA, Toshihiro, Chiryu-shi, Aichi 472-8686 (JP)
(74) Representative: Grünecker Patent- und Rechtsanwälte PartG mbB
(86) International application number: PCT/JP2018/018533
(87) International publication number: WO 2019/220499

(56) References cited:
- EP-A1- 3 319 408
- WO-A1-2017/077594
- JP-A- 2004 182 359
- JP-A- 2017 034 169
- JP-A- 2018 043 298
- JP-A- 2018 046 045
- JP-A- 2018 046 045

## Description

### Technical Field

The present disclosure relates to a mounter provided with a lead wire cutting unit.

### Background Art

In a lead wire cutting unit described in JP-A-2017-034169, multiple lead wires of a lead component are cut by a pair of cutting blades moving relatively. In addition, multiple scale lines are formed on each of a pair of cutting blade holding members for holding the pair of cutting blades by cutting grooves thereon. These scale lines are used as an index of position alignment when removing the lead component whose lead wires are cut off.

EP 3 319 408 A1 discloses a cut and clinch device where a movable section is slidable with respect to main body section. The main body section is configured from main body first section and main body second section that is removably attached to the main body first section, and a first insertion hole is formed in the main body second section. The movable section is configured from movable first section and movable second section that is removably attached to the movable first section, and second insertion hole is formed in the movable second section. A lead is cut by the movable section being slid with the lead inserted into the first insertion hole and the second insertion hole. In a device configured as such, recognition mark 230 is provided on the movable second section and the main body second section, and the types of the movable second section and the main body second section are recognized based on image data of the recognition marks. By this, it is possible to appropriately check the type of the portion that cuts a lead.

JP 2018 046045 A discloses a mounter comprising a lead wire cutting unit in accordance with the preamble of independent claim 1.

### Summary of the Invention

### Technical Problem

A problem to be solved by the present disclosure is how to improve a lead wire cutting unit and a mounter provided with the lead wire cutting unit and more particularly, for example, how to enable multiple lead wires of a lead component to be cut well.

### Solution to Problem

### Advantageous Effect of the Invention

The problem is solved with a mounter comprising a lead wire cutting unit in accordance with independent claim 1. Preferred embodiments are set out in the dependent claims. In the lead wire cutting unit according to the present disclosure, at least one fiducial mark is provided on each of one or more of multiple cutting blade holding members for holding multiple cutting blades. Additionally, since a relative position of at least one fiducial mark on each of the one or more of the multiple cutting holding members for holding the multiple cutting blades and each of one or more of the multiple cutting blades is determined in advance, in the event that a position of the at least one fiducial mark is acquired, a position of the one or more of the multiple cutting blades is determined based on the position so acquired and the relative position. The positioning accuracy of the multiple lead wires with respect to the one or more cutting blades can be improved, thereby making it possible to cut the multiple lead wires well. There is made no description of a relative position between each of the scales and the cutting blades (blade faces 77a, 77b) in JP-A-2017-034169.

### Brief Description of Drawings

[Fig. 1] Fig. 1 is a perspective view of a mounter according to an embodiment of the present disclosure.
[Fig. 2] Fig. 2 is a perspective view showing a part of a component insertion device of the mounter.
[Fig. 3] Figs. 3a, 3c are perspective views of a lead component, which constitutes a work target of the mounter, and Figs. 3b, 3d are side views of the lead component.
[Fig. 4] Fig. 4 is a front view of a chuck of the component insertion device.
[Fig. 5] Fig. 5 is a perspective view of lead wire cutting units of the mounter.
[Fig. 6] Fig. 6 is a side view showing conceptually an interior of the lead wire cutting unit.
[Fig. 7] Fig. 7 is a plan view showing conceptually a lead wire cutting mechanism of the lead wire cutting unit.
[Fig. 8] Figs. 8a, 8b are plan views of a stationary blade holding member of the lead wire cutting mechanism.
[Fig. 9] Figs. 9a, 9b are drawings showing a relative position between the lead component and a main body of the lead wire cutting unit.
[Fig. 10] Fig. 10 is a block diagram showing conceptually a periphery of a control device of the mounter.
[Fig. 11] Fig. 11 is a drawing showing conceptually information included in a 2D code affixed to the stationary blade holding member.
[Fig. 12] Fig. 12 is a drawing showing conceptually information recorded in a tag affixed to the lead wire cutting unit.
[Fig. 13] Fig. 13 is a drawing showing conceptually target lead wire information stored in a memory section of the control device.
[Fig. 14] Fig. 14 is a drawing showing conceptually information stored in association with a stationary blade ID in the memory section.
[Fig. 15] ]Fig. 15 is a drawing showing conceptually information stored in association with a unit ID in the memory section...
[Fig. 16] Fig. 16 shows a display screen of a display of the mounter.
[Fig. 17] Fig. 17 shows another display screen of the display.
[Fig. 18] Fig. 18 shows a further display screen of the display.
[Fig. 19] Fig. 19 shows a display screen of the display.
[Fig. 20] Fig 20 shows another display screen of the display.
[Fig. 21] Fig. 21 is a flowchart illustrating a pre-work process program stored in the memory section.
[Fig. 22] Fig. 22 is a flowchart illustrating a part of the program.
[Fig. 23] Fig. 23 is a flowchart illustrating another part of the program.
[Fig. 24] Fig. 24 is a flowchart illustrating a further part of the program.
[Fig. 25] Fig. 25 is a flowchart illustrating a part of the program.
[Fig. 26] Fig. 26 is a flowchart illustrating a lead wire positioning program stored in the memory section.
[Fig. 27] Fig. 27 is a flowchart illustrating a stationary blade history management program stored in the memory section.
[Fig. 28] Fig. 28 is a flowchart illustrating a movable blade history management program stored in the memory section.

### Description of Embodiment

Hereinafter, a mounter, which constitutes an embodiment of the present disclosure, will be described in detail based on drawings.

### Example

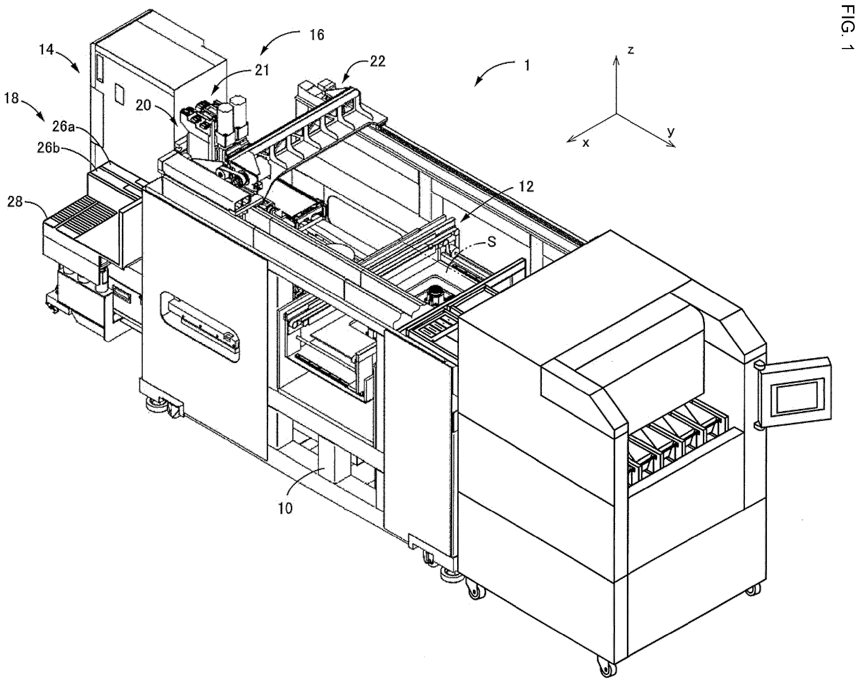

Mounting machine 1 includes, as shown in Fig. 1, assembly apparatus main body 10, board conveyance and holding device 12, component supply device 14, component insertion device 16, lead wire cutting device 18, and the like. Board conveyance and holding device 12 conveys and holds circuit board S (hereinafter, referred to simply as "board S"). In Fig. 1, x denotes a conveyance direction in which board conveyance and holding device 12 conveys board S, y a width direction of board S, and z a thickness direction of board S. y denotes a front-rear direction of mounter 1, and z an up-down direction thereof. These x-direction, y-direction, and z-direction are orthogonal to one another.

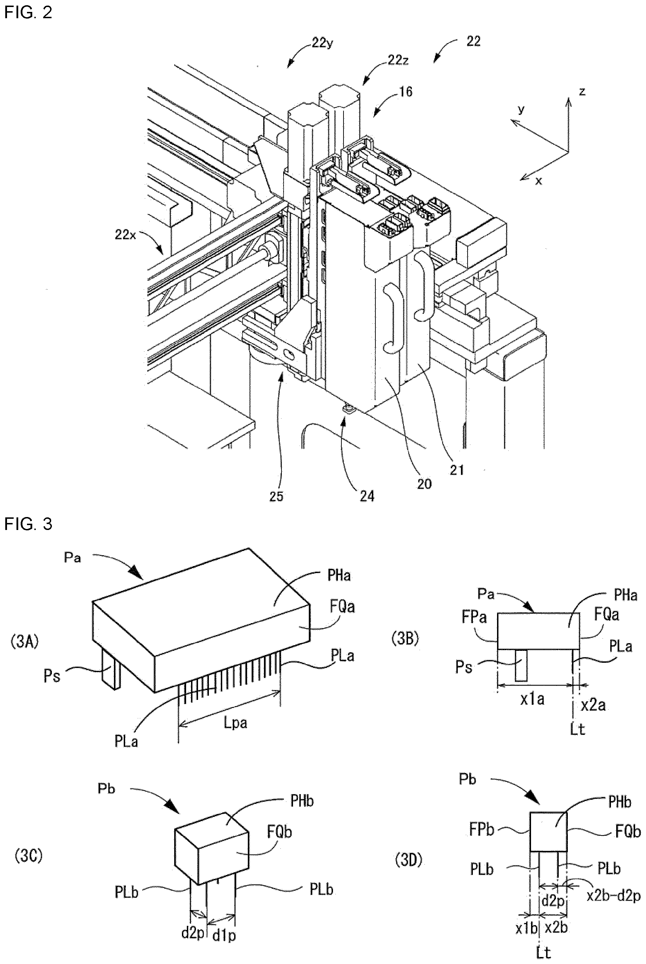

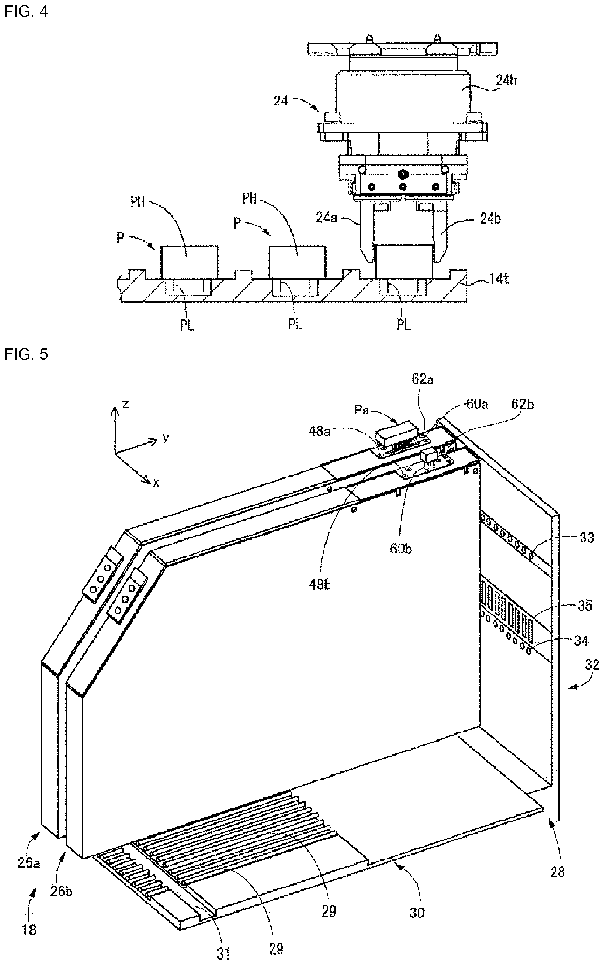

Component supply device 14 includes multiple trays 14t (refer to Fig. 4) and supplies lead component P, which is inserted into board S to be mounted thereon. Each of multiple trays 14t accommodates multiple lead components P. As shown in Figs. 3a to 3d, lead components Pa, Pb include component main bodies PHa, PHb and multiple lead wires PLa, PLb, respectively, and in lead components Pa, Pb, the numbers of lead wires PLa, PLb, relative positions of lead wires PLa, PLb relative to component main bodies PHa, PHb, and the like are different from each other. Hereinafter, in the case that lead components Pa, Pb do not have to be distinguished from each other in referring to lead components Pa, Pb collectively, or in a similar case, lead components Pa, Pb, component main bodies PHa, PHb, and lead wires PLa, PLb will be referred to simply as lead component P, component main body PH, and lead wire PL without appending subscripts a, b...

Component insertion device 16 conveys lead component P and inserts lead wire PL into a through hole in lead wire cutting unit 26 of lead wire cutting device 18 or inserts lead wire PL into a predetermined through hole in multiple through holes formed in board S conveyed and held by board conveyance and holding device 12. Component insertion device 16 includes, as shown in Fig. 2, work heads 20, 21, work head moving device 22, and the like. Work head moving device 22 moves work heads 20, 21 in the x-direction, the y-direction, and the z-direction and includes x-direction moving device 22x, y-direction moving device 22y, z-direction moving device 22z, and the like. These x-direction moving device 22x, y-direction moving device 22y, and z-direction moving device 22z each include a driving source such as an electric motor, and positions of work heads 20, 21 in the x-direction, the y-direction, and the z-direction are controlled by controlling the corresponding electric motors.

For example, a component holding tool such as chuck 24 shown in Fig. 4 or the like is attached to each of work heads 20, 21. Additionally, camera 25 as an imaging device is attached to a head holding body in such a manner as to move in the x-direction, the y-direction, and the z-direction together with work head 20. Chuck 24 includes chuck main body 24h and pair of claw sections 24a, 24b which are held to chuck main body 24h in such a manner as to move towards and away from each other. Chuck 24 grips and holds lead component P with pair of claw sections 24a, 24b.

Lead wire cutting device 18 includes multiple lead wire cutting units 26a, 26b..., and among them, lead wire cutting units 26a, 26b are different from each other in type, as shown in Fig. 5. Hereinafter, in the case that lead wire cutting units 26a, 26b do not have to be distinguished from each other as in referring to lead wire cutting units 26a, 26b collectively, lead wire cutting units 26a, 26b will be referred to simply as lead wire cutting unit (hereinafter, referred to simply as unit) 26 without appending subscripts a, b.... The same applies to constituent elements of unit 26. Each unit 26 is held by unit holding member 28. Unit holding member 28 includes holding table 30 and positioning plate 32. Holding table 30 includes slots 29, configured by multiple holding grooves extending parallel to one another, and engaging groove 31, and positioning plate 32 includes two positioning recessed sections 33, 34 and connector connection sections 35; which are respectively provided for each of slots 29. A power supply for mounter 1, main control device 100, and the like are electrically connected to unit holding member 28.

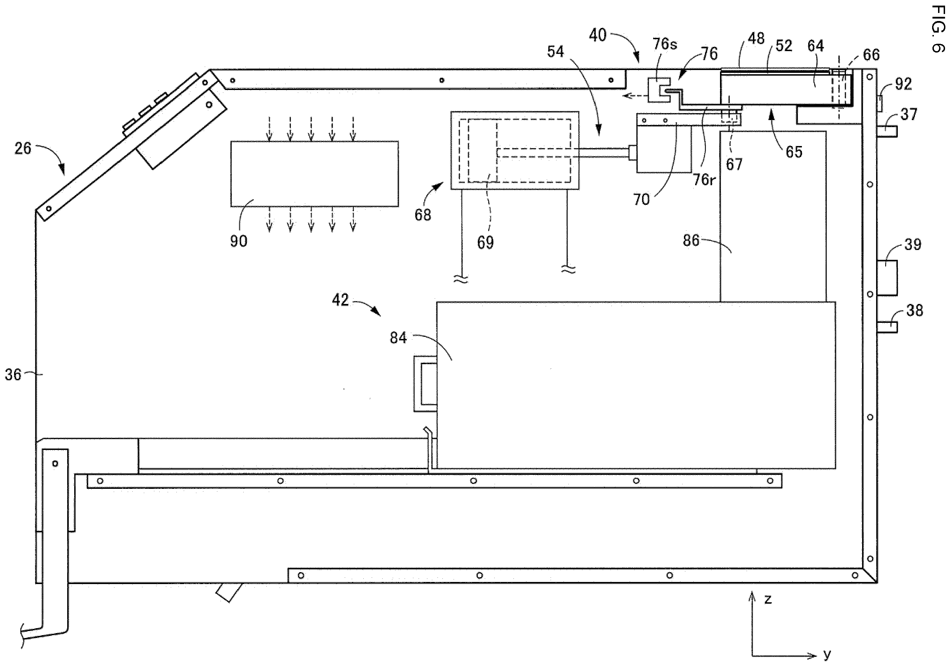

As shown in Fig. 6, unit 26 includes two positioning protruding sections 37, 38 and connector 39, which are provided on an end face of unit main body 36, and an engagement projecting section provided on a bottom face of unit main body 36. Unit 26 is held in slot 29 with the engagement projecting section brought into engagement with engagement groove 31 in holding table 30, protruding sections 37, 38 fitted in positioning recessed sections 33, 34, respectively, on unit holding member 28, and connector 39 fitted in connector connection section 35.

Units 26 are held onto unit holding member 28 by being aligned side by side in the x-direction, while taking a posture in which a longitudinal direction of unit main body 36 constitutes the y-direction and a width direction thereof constitutes the x-direction. In this state, units 26 and unit holding member 28 are electrically connected together, whereby units 26 and the power supply for mounter 1 and main control device 100 are electrically connected. In the present embodiment, each unit 26 occupies a space corresponding to three slots 29.

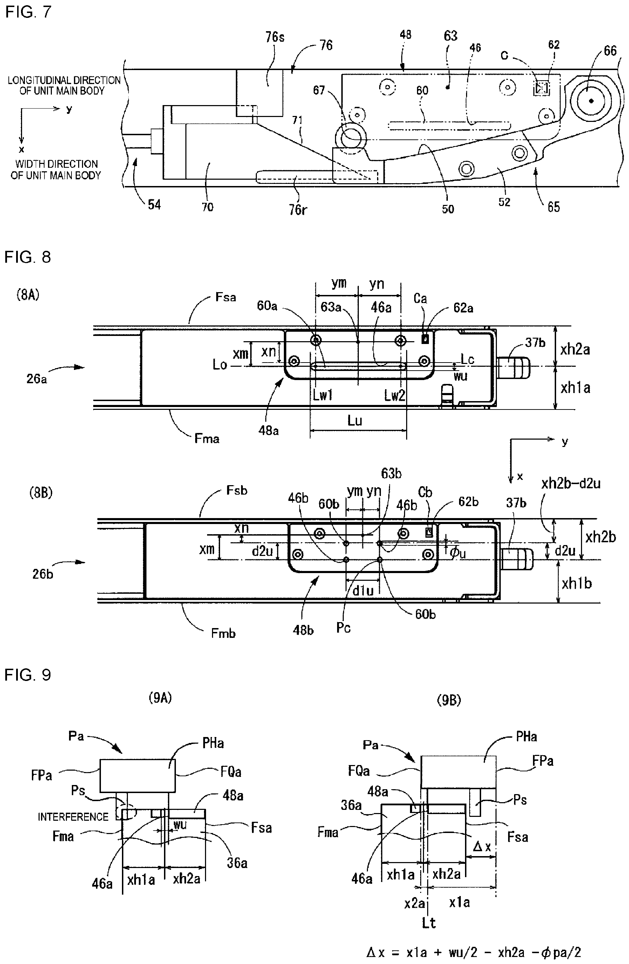

As show in Fig. 7, unit 26 cuts multiple lead wires PL of lead component P by a relative movement of stationary blade 46 and movable blade 50 as multiple cutting blades, and includes unit main body 36, lead wire cutting mechanism 40 (refer to Fig. 7), lead wire piece recovery mechanism 42, and the like. Lead wire cutting mechanism 40 includes stationary blade holding member 48 and movable blade holding member 52, which constitutes cutting blade holding members, as well as driving device 54 for driving movable blade holding member 52. Stationary blade holding member 48 and movable blade holding member 52 are provided in such a state that stationary blade 46 and movable blade 50 face each other in the width direction (the x-direction) of unit main body 36 and are aligned in the up-down direction.

Stationary blade holding member 48 has a flat plate-like shape in general and is detachably attached to an upper portion of unit main body 36 at a peripheral portion thereof. Stationary blade holding member 48 has one or more through holes 60 where multiple lead wires PL can be inserted, and a part of each edges of one or more trough holes 60, of which part lying remote from movable blade holding member 52 in the width direction, constitutes stationary blade 46. Thus, one or more stationary blades 46 are provided on stationary blade holding member 48.

One or more through holes 60 each have a size allowing lead wire PL to be inserted thereinto and are ordinarily designed into an opening as small as possible in consideration of a cross-sectional shape of the lead wire, a degree of a curved portion of the lead wire, and the like, on top of a point of the view to prevent an ingress of a foreign matter. The lead wire does not necessarily have to extend straight, rather it may be bent or curved within a predetermined allowable range, whereby the opening of through hole 60 is set in consideration of a degree at which the lead wire is curved.

Seal-like label 62 is affixed to an upper face of stationary blade holding member 48 in such a manner as to be imaged by camera 25, and on seal-like label 62, two-dimensional code C (hereinafter, occasionally referred to as 2D code) is printed as an information record section where multiple pieces of information are recorded. Information recorded in 2D code C is acquired based on a captured image of 2D code C which is captured by camera 25. Label 62 can be formed from, for example, paper or plastic.

In addition, at least one or more fiducial marks 63 are formed at an intermediate portion of the upper face of stationary blade holding member 48. In the present embodiment, single dot-like fiducial mark 63, which forms a circle in general, is formed through baking using laser or the like. Fiducial mark 63 is provided to improve the positioning accuracy at which the lead wire PL is positioned with respect to stationary blade 46 before the lead wire is cut in unit 26.

For example, a configuration may be considered in which a relative position of a unit side fiducial face, which is the end face of unit main body 36 facing to positioning plate 32, and stationary blade 46 is stored in advance, a position of the unit side fiducial face is specified based on a captured image captured by camera 25, so that a position of stationary blade 46 relative to the unit side fiducial face is specified based on the position so specified and the relative position so stored. However, there have been problems in that the actual relative position of the unit side fiducial face and stationary blade 46 varies due to variations in individual units 26, and the positioning accuracy is deteriorated in positioning the multiple lead wires with respect to stationary blade 46.

Then, in the present embodiment, fiducial mark 63 is provided on the stationary blade holding member itself, so that relative position information, which is information indicating a relative position between fiducial mark 63 and one or more stationary blades 46, is stored in advance. In the present embodiment, as the relative position information, information is stored which indicates a relative position between fiducial mark 63 and a predetermined reference point or reference line on each of one or more through holes 60. Stationary blade 46 is made up of a part of an edge of through hole 60, and hence, a relative positional relationship between the reference point or reference line of through hole 60 and stationary blade 46 is already known. There is also a case in which the reference line or reference point of through hole 60 is set at stationary blade 46. Therefore, in the event that a relative position between fiducial mark 63 and the reference point or reference line of each of one or more through holes 60 is determined, a relative position between fiducial mark 63 and one or more stationary blades 46 is uniquely determined. It can be considered from what is described above that the relative position between the fiducial mark 63 and the reference point or reference line of one or more through holes 60 is the relative position between fiducial mark 63 and one or more stationary blades 46. Incidentally, a center point of through hole 60 or the like can be adopted for the reference point, and a line passing through the center point of through hole 60, a line passing over the stationary blade, a line indicating a region where the lead wire can be inserted, or the like can be adopted for the reference line; however, the reference point or the reference line may also be set at a portion where no object exists.

As shown in Figs. 6, 7, movable blade holding member 52 is detachably attached to arm section 64 extending in the longitudinal direction in general and having a curvilinear shape, and movable member 65 is configured by movable blade holding member 52 and arm section 64. A first longitudinal end portion of movable member 65 is rotatably held to unit main body 36 with shaft member 66 such as a pin or the like, and roller 67 is held to a second longitudinal end portion of movable member 65 in such a manner as to rotate relatively around an axis extending in the up-down direction below stationary blade holding member 48. An upper end edge at a side of movable blade holding member 52 which faces stationary blade 46 constitutes movable blade 50. Incidentally, a return spring, not shown, is provided between movable member 65 and unit main body 36.

Driving device 54 includes air cylinder 68, acting as a driving source, and inclined member 70 configured to be activated by air cylinder 68. Air cylinder 68 includes piston 69 provided slidably in a cylinder main body and two air chambers which are divided by piston 69, and inclined member 70 is held to a piston rod of piston 69 in such a manner as to move together with the piston rod. Inclined member 70 extends in a longitudinal direction (the y-direction) of unit main body 36 and has inclined surface 71 which is inclined from a movable blade side towards a stationary blade side in the width direction (the x direction) as it extends away from movable blade holding member 52 in the longitudinal direction. Inclined surface 71 can be brought into engagement with roller 67 of movable blade holding member 52.

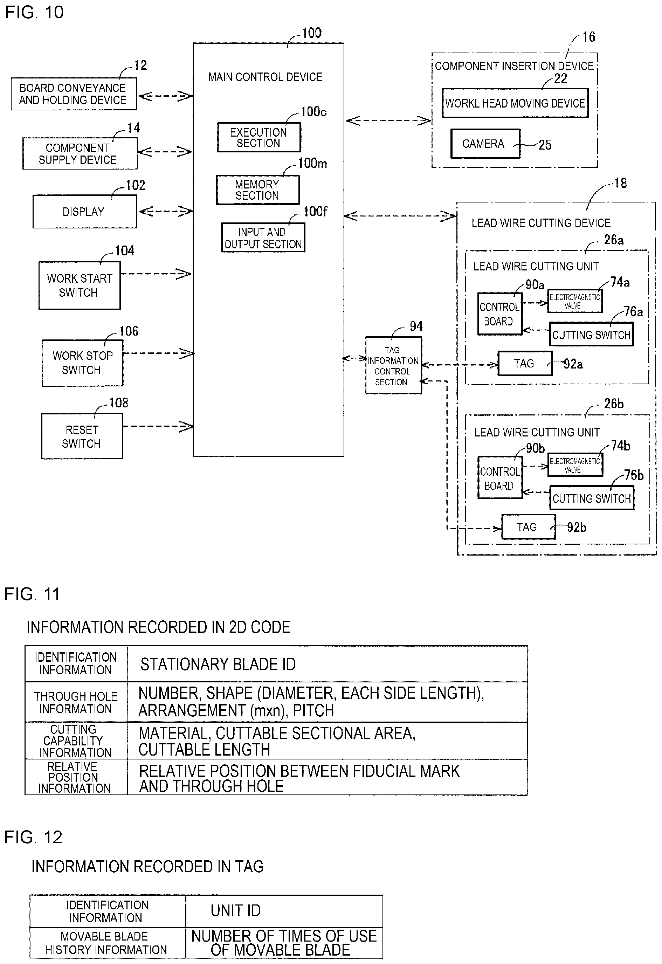

In addition, electromagnetic valve 74 (refer to Fig. 10) is provided between the two air chambers in air cylinder 68 and an air source, not shown, which is provided in mounter 1 and the atmosphere. Electromagnetic valve 74 causes the air source to selectively communicate with either of the two air chambers, whereby piston 69 is caused to advance or retreat, in other words, piston 69 is caused to move towards or away from movable blade holding member 52. Further, cutting switch 76 is provided on lead wire cutting mechanism 40. Cutting switch 76 is designed to detect an arrival of movable blade holding member 52 at a cutting position and includes rod 76r provided on arm section 64 in such a manner as to rotate together with arm section 64 and electromagnetic detection section 76s provided in a position corresponding to the cutting position of movable blade holding member 52 to detect rod 76r. Cutting switch 76 outputs an ON signal when rod 76r is detected by detection section 76s.

In the presents embodiment, inclined surface 71 stays away from roller 67 when piston 69 is in a retreat end position. Movable blade holding member 52 stays in a retraction position, in which movable blade 50 stays away from stationary blade 46. Piston 69 is advanced by cylinder 68, whereby inclined member 70 is advanced. Inclined face 71 is brought into engagement with roller 67, rotating movable member 65 around shaft member 66 towards stationary blade 46. This causes movable blade holding member 52 to arrive at a cutting position, whereby lead wire P is cut by stationary blade 46 and movable blade 50, and cutting switch 76 outputs an ON signal. In addition, in the case that piston 69 is caused to retreat to the retreat end position by cylinder 68, movable blade holding member 52 is returned to a retraction position by the returns spring.

Stationary blade holding member 48a attached to unit 26a and stationary blade holding member 48b attached to unit 26b have different through holes 60a, 60b. As shown in Fig. 8a, single through hole 60a, extending in the longitudinal direction, is formed in stationary blade holding member 48a, while in total four (2x2) through holes 60b are formed in stationary blade holding member 48b, the four through holes being configured by two transversely aligned pairs of through holes spaced apart from each other in the longitudinal direction.

Then, as shown in Fig. 11, a stationary blade ID, which is identification information for discriminating stationary blade holding member 48 from the other stationary blade holding members 48, through hole information, which is information on through holes 60 formed in stationary blade holding member 48, cutting capability information, which is information on a cutting capability of corresponding unit 26, relative position information, which is information indicating a relative position between fiducial mark 63 and the predetermined one or more reference points or reference lines of each of one or more through holes 60, and the like are recorded in 2D code C on label 62 affixed to stationary blade holding member 48 in question.

Stationary blade ID is given to each stationary blade holding member 48, and should stationary blade holding members 48 be of the same type (having through holes 60 of the same shape), stationary blade IDs of those stationary blade holding members 48 become different information.

Through hole information includes information indicating the numbers of through holes 60a, 60b, shapes (including sizes) of through holes 60a, 60b, and the like. Through hole information on through hole 60a includes, as shown in Fig. 8a, information indicating single piece, width wu, and longitudinal length Lu, and the like, and information on through holes 60b includes, as shown in Fig. 8b, four pieces, diameter ϕu, arrangement (2x2), pitches d1u, d2u, and the like. Since parts of edges of through holes 60a, 60b constitute stationary blades 46a, 46b, respectively, cutting blade information, which is information on stationary blades, is determined uniquely based on the through hole information. Due to this, it is considered that the through hole information constitutes the cutting blade information.

Cutting capability information includes information indicating a cuttable sectional area which constitutes a maximum value of a total of sectional areas of lead wires that can be cut by unit 26, information indicating a cuttable length which constitutes a minimum value of a length of a lead wire that can be cut by unit 26, and the like. The cuttable sectional area is determined by materials of stationary blade 46 and movable blade 50, the driving force of driving device 54, and the like. In addition, the cuttable sectional area differs depending upon a material of a lead wire, and hence, in the present embodiment, cuttable sectional areas are stored in association with materials of lead wires.

Incidentally, cuttable sectional areas and cuttable lengths can be acquired in advance through experiments, simulations, or the like. Also, cuttable sectional areas and cuttable lengths can be determined in consideration of a safety rate. Further, the cutting capability information is allowed to include information indicating multiple combinations (ϕ, n) of diameters(ϕ) of lead wires that can be cut and a maximum number (n) of lead wires that can be cut. Furthermore, the cutting capability information does not necessarily have to include the information indicating cuttable lengths.

The relative position information includes information indicating distances in the x-direction and the y-direction between fiducial mark 63 and the reference point or reference line of one or more through holes 60. For example, relative position information on stationary blade holding member 48a shown in Fig. 8a includes information indicating distances xm, xn defined in the width direction between fiducial mark 63a and line Lo passing through a transverse center of through hole 60a as a reference line thereof and line Lc including cutting blade 46 and distances ym, yn defined in the longitudinal direction between fiducial mark 63a and reference lines Lw1, Lw2 regulating both ends of a portion where the width of through hole 60a becomes a maximum width wu. In addition, relative position information on stationary blade holding member 48b shown in Fig. 8b includes information indicating distances xm, xn, ym, yn defined in the x-direction and the y-direction between fiducial mark 63b and center points Pc as reference points of four individual through holes 60b.

Lead wire piece recovery mechanism 42 recovers lead wire pieces resulting from cutting and includes recovery box 84 and recovery passage 86. Recovery passage 86 is provided open below through hole 60 of stationary blade holding member 48 of lead wire cutting mechanism 40. Lead wire pieces recovered into recovery box 84 can easily be discarded by detaching recovery box 84 from unit main body 36.

Control board 90, acting as a unit control device made up mainly of a computer, is provided on unit 26. Cutting switch 76, electromagnetic valve 74, and the like are connected to an input and output section of control board 90. Control board 90 causes electromagnetic valve 74 to rotate movable blade holding member 52 so as to cut lead wire PL. In addition, every time cutting switch 76 outputs an ON signal, the ON signal, that is, cutting information, which is information indicating that lead wire PL is cut, is supplied to main control device 100.

Tag 92, acting as a unit information record section, is provided on the end face of unit 26. As shown in Fig. 12, a unit ID, which is identification information given individually to each of multiple units 26, movable blade history information, which is information indicating the number of times of using movable blade 50, and the like are recorded in tag 92. Tag 92 is positioned in such a manner as to face tag information control section 94 provided on unit holding member 28, and the information recorded in tag 92 by tag information control section 94 is read or rewritten.

As shown in Fig. 10, main control device 100, which is made up mainly of a computer, is provided in mounter 1. Main control device 100 includes execution section 100c, memory section 100m, output and input and output section 100f, and the like, and board conveyance and holding device 12, component supply device 14, component insertion device 16, lead wire cutting device 18, tag information control section 94, display 102, work start switch 104, work stop switch 106, reset switch 108, and the like are connected to input and output section 100f.

Work information (also referred to as JOB information) or the like is stored in memory section 100m (which can include, for example, ROM, RAM, and the like) of main control device 100. The work information is supplied from a host computer or is inputted directly by an operator. The work information includes target lead component information as lead component information, which is information on a target lead component which is a lead component constituting a work target (specifically speaking, a cutting target of unit 26) of mounter 1 and target lead wire information as lead wire information, which is information on a target lead wire provided on each of target lead components. Additionally, the work information also includes information indicating a holding position of a unit held by unit holding member 28 with respect to unit holding member 28.

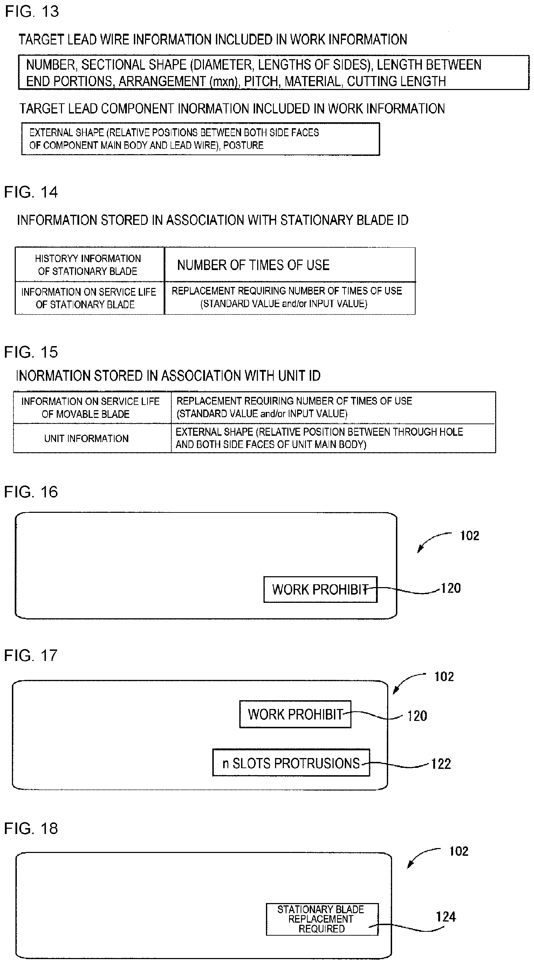

As shown in Fig. 13, the target lead wire information includes information indicating the number of target lead wires, sectional shape (for example, a diameter ϕ when a sectional shape is circular, lengths a, b of sides when a sectional shape is rectangular), length Lp from a first end portion to a second end portion when multiple target lead wires are provided in such a manner as to be aligned into a row, arrangement (mxn), pitch, material and cutting length of target lead wires, and the like. For example, information on target lead wires PLa shown in Figs. 3a, 3b includes 18 wires, diameter ϕpa, length Lpa between end portions, material (copper), cutting length Ga, and the like, and information on target lead wires PLb shown in Figs. 3c, 3d includes four wires, diameter ϕpb, arrangement (2×2), pitches d1p, d2p, material (iron), cutting length Gb, and the like.

In addition, the target lead wire information is allowed to include information indicating a sectional area of each of target lead wires and a total sectional area of multiple target lead wires as a sectional shape.

The target lead component information is information on an external shape of a target lead component and includes information indicating distances between transverse end portions of a component main body and a reference point of a lead wire and the like. The end portions of the component main body constitute portions which project most in the width direction. In the case that the component main body has a rectangular parallelepiped shape, the end portions correspond to end faces in the width direction, and in the case that the component main body has an irregular shape, the end portions correspond to portions which project most. The reference point of the lead wire can be a center point of a section of the lead wire, a predetermined point on a side face, or the like.

For example, information on target lead component Pa shown in Figs. 3a, 3b includes distance x1a defined between a center point (a line passing through the center point is denoted by Lt) of a cross section of target lead wire PLa and first end face FPa as a first transverse end portion of component main body PHa, distance x2a defined between the center point and second end face FQa as a second transverse end portion of component main body PHa, a posture, and the like. Information on target lead component Pb shown in Figs. 3c, 3d includes distance x1b defined between a center point of a cross section of one of multiple target lead wires PLb and first side face FPb as a first end portion of component main body PHb, distance x2b defined between the center point and second side face FQb as a second end portion, and the like. As shown in Fig. 3d, in the event that distances x1b, x2b defined between the center point of one target lead wire PLb in four target lead wires PLb and first side face FPb and second side face FQb are acquired, distances defined between center points of remaining target lead wires PLb and first side face FPb and second side face FQb can be acquired by considering pitch d2b of target lead wires PLb.

The posture of the target lead component means an orientation of the target lead component with respect to unit 26 when a target lead wire and stationary blade 46 are positioned in cutting the target lead wire. For example, as shown in Fig. 9, in target lead component Pa in which component main body PHa includes stay Ps, there may be a case in which an orientation of target lead component Pa is determined so that stay Ps does not interfere with unit main body 36a. In unit 26a, a distance (xh1a+wu/2) defined between stationary blade 46a and first side face Fma, which is a side face on a movable blade side of unit main body 36a, is greater than a distance (xh2a-wu/2) defined between stationary blade 46a and second side face Fsa, which is a side face on a stationary blade side of unit main body 36 (xh1a+wu/2>xh2a-wu/2). Due to this, as shown in Fig. 9a, when target lead component Pa is attached in such an orientation that stay Ps is situated on the movable blade side, in other words, in such an orientation that stay Ps is situated on the side facing first side face Fma, stay Ps interferes with unit main body 36a. In contrast to this, as shown in Fig. 9B, when target lead component Pa is attached in such an orientation that stay Ps is situated on the stationary blade side, in other words, in such an orientation that stay Ps is situated on the side facing second side face Fsa, the interference of stay Ps with unit main body 36a can be avoided. It can be concluded from what has been described above that the information indicating the posture of target lead component Pa constitutes information indicating that target lead component Pa is in such an orientation that first side face FPa of component main body PHa is situated on the stationary blade side (the side facing second side face Fsa) of unit main body 36a.

Respective pieces of information of stationary blade holding member 48 and unit 26 are stored in association with the stationary blade ID and the unit ID, respectively, in memory section 100m. For example, as shown in Fig. 14, history information for one or more stationary blades 46 and information on the service life of one or more stationary blades 46 are stored in association with the stationary blade ID. The history information for one or more stationary blades 46 includes the numbers of times of using one or more stationary blades 46. The information on the service life includes replacement requiring numbers of times of use of one or more stationary blades 46, which are the numbers of times of use thereof before information requiring a replacement of one or more stationary blades 46 is issued. Normally, although a standard value is stored as a replacement requiring number of times of use, a value inputted by the operator may also be allowed to be stored.

In addition, as shown in Fig. 15, information on a service life of movable blade 50 such as a replacement requiring number of times of use thereof or the like, unit information, and the like are stored in association with the unit ID in memory section 100m. The unit information is information on an external shape of unit main body 36, and information indicating distances defined between both transverse side faces of unit main body 36 and reference points or reference lines of one or more through holes 60 correspond to the unit information. In the event that the distances defined between both the transverse side faces of unit main body 36 and the reference points or reference lines of one or more through holes 60 are acquired, distances defined between the transverse side faces of unit main body 36 and one or more stationary blades 46 are determined. Due to this, it can be understood that the unit information constitutes information indicating relative positions (distances) between the transverse side faces Fm, Fs of unit main body 36 and one or more stationary blades 46.

For example, information on unit 26a shown in Fig. 8a includes information indicating distances xh1a, xh2a defined between line Lx, which is a reference line of through hole 60a, passing through a transverse center of through hole 60a and first side face Fma and second side face Fsa of unit main body 36 or the like, and information on unit 26b shown in Fig. 8b includes information indicating distances xh1b, xh2b defined between center point Pc, which is one of reference points of through hole 60b, and first side face Fmb and second side face Fsb of unit main body 36 or the like. As in the case with the case described above, in the event that the distances defined between the reference point of one of multiple through holes 60b and first side face Fmb and second side face Fsb are obtained, distances defined between the respective reference points of all through holes 60b and first side faces Fmb, second side face Fsb can be acquired by taking pitch d2u into consideration.

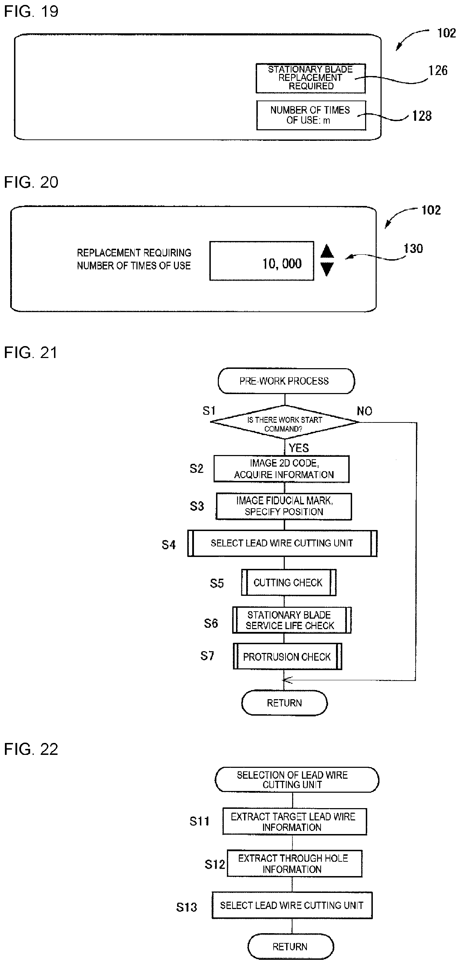

Display 102 displays a state of mounter 1, and for example, as shown in Fig. 16, display 102 displays information "work prohibit" 120, which indicates that a start of work is prohibited, displays, as shown in Fig. 17, displays information "n slots protrusion" 122, which indicates a protrusion amount when lead component P protrudes from unit 26 in the width direction (the x-direction) with lead wire PL positioned in a position where lead wire P comes into abutment with stationary blade 46, together with information "work prohibit" 120, or displays, as shown in Figs. 18, 19, information "stationary blade replacement required" 124 and "movable blade replacement required" 126, which indicate that the numbers of times of use of stationary blade 46 and movable blade 50 reach a replacement requiring number of times of use. Information "movable blade replacement required" 126 is displayed together with information "number of times of use: n times" 128, which indicates the number of times of use of the movable blade. In addition, display 102 also displays, as shown in Fig. 20, operation screen 130 for use in changing the number of times of use of stationary blade 46 or movable blade 50 from a standard value. The standard value for the replacement requiring number of times of use of stationary blade 46 or movable blade 50 is displayed on operation screen 130, so that the replacement requiring number of times of use can be incremented or decremented from the standard value.

In mounter 1, in the case that a predetermined work start condition, such as a condition that work start switch 104 is switched on by the operator, is established, a work start command is outputted. With the work start command so outputted, a pre-work process is performed, and a lead wire cutting operation is performed after the pre-work process has been performed. In addition, in the case that a predetermined work stop condition, such as a condition that work stop switch 106 is switched on, is established, a work stop command is outputted. With the work stop command so outputted, the lead wire cutting operation is stopped, and an after-work process is performed. Further, reset switch 108 is a switch configured to be operated in deleting the predetermined information.

The pre-work process is executed by executing a pre-work processing program, which is illustrated by a flowchart in Fig. 21 in main control device 100. In step 1 (hereinafter, referred to simply as S1, which will be similarly applied to other steps), it is determined whether the work start command is issued. If the determination is YES, in S2, information necessary for a lead wire cutting operation or the like is acquired in main control device 100. For example, the 2D code C affixed to stationary blade holding member 48 of each of units 26 is imaged by camera 25, the stationary blade ID, which is the identification information, the through hole information, the cutting capability information, and the relative position information are acquired based on the captured image and are then stored in memory section 100m. The information recorded in tag 92 on each of units 26 is acquired via tag information control section 94 and is then stored in memory section 100m. In S3, in each of units 26, fiducial mark 63 is imaged, and a position of fiducial mark 63 is specified in both the x-direction and the y-direction. Then, in S4, unit 26 is selected, in S5, a cutting check is performed, in S6, a stationary blade service life check is performed, and in S7, a protrusion check is performed.

An example of a selection of unit 26 performed in S4 will be illustrated by a flowchart shown in Fig. 22. In S 11, the number of lead wires PL, sectional shape, length between end portions, arrangement, pitch, and the like are extracted (hereinafter, reading a part of information stored in memory section 100m and confirming it may be referred to as extraction from time to time) from the target lead wire information for each of target lead components P, in S12, the through hole information or the like for each of stationary blade holding members 48 of multiple units 26 is extracted, and in S13, the pieces of through hole information so extracted are compared, whereby unit 26 including through hole 60 into which target lead wire PL can be inserted is selected from multiple units 26 for each of target lead components P, and for example, unit 26a is selected for lead component Pa shown in Fig. 3, and unit 26b is selected for lead component Pb shown in Fig. 3b.

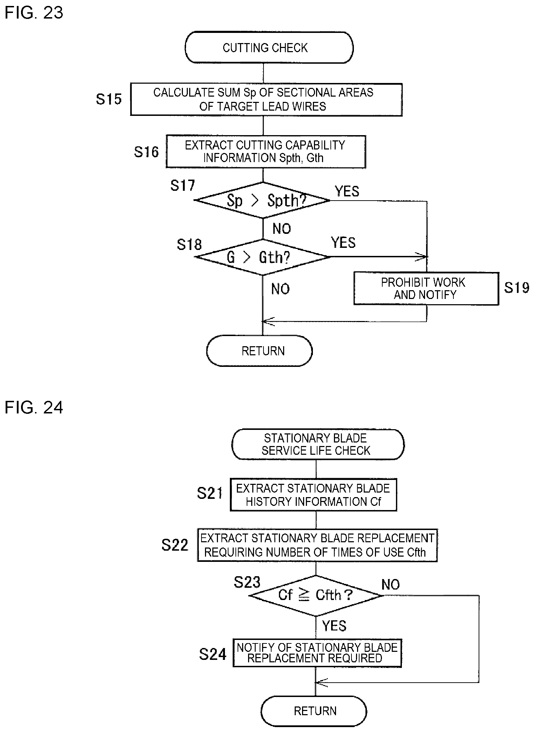

An example of a cutting check performed in S5 will be illustrated by a flowchart shown in Fig. 23. In S15, the number, material, sectional shape, and cutting length G of target lead wire PL are extracted from the target lead wire information for each of target lead components P, and sum Sp of sectional areas of multiple target lead wires PL is calculated based on the number, sectional shape, and the like of target lead wire PL. In S 16, the cutting capability information of stationary blade holding member 48 of each selected unit 26 is extracted for each of target lead components P. In S 17, it is determined whether calculated sum Sp of sectional areas of target lead wires PL is greater than cuttable sectional area Sph, which is determined by the material of target lead wire PL. In S18, it is determined whether cutting length G is longer than cuttable length Gth. If either of the determinations made in S17, S18 is YES, in S19, a lead wire cutting operation in mounter 1 is prohibited, and information "work prohibit" 120 is displayed on display 102. In the present embodiment, a start of the lead wire cutting operation is prohibited.

An example of a stationary blade service life check performed in S6 will be illustrated by a flowchart shown in fig. 24. In S21, the number of times of use Cf of the one or more stationary blades is extracted based on the stationary blade ID of stationary blade holding members 48 of each of multiple units 26, and in S22, stationary blade replacement requiring number of times of use Cfth is extracted. Then, in S23, it is determined whether number of times of use Cf is equal to or more than stationary blade replacement requiring number of times of use Cfth. If the determination is YES, information "stationary blade replacement required" 124 is displayed on display 102. In this case, a start of the work is permitted.

In the present embodiment, since 2D code C is imaged to acquire the stationary blade ID in S2 as described above, that is, every time a work start command is outputted, information "stationary blade replacement required" 124 is displayed in a case that number of times of use Cf, which is stored and linking to the stationary blade ID, is equal to or more than stationary blade replacement requiring number of times of use Cfth. Then, when stationary blade holding member 48 is replaced with another stationary blade holding member 48 after the operation has been stopped, 2D code C is changed to another 2D code C, and the stationary blade ID is changed to another stationary blade ID, whereby in the case that number of times of use Cf stored in association with the changed stationary blade ID is smaller than stationary blade replacement requiring number of times of use Cfth, information "stationary blade replacement required" 124 is not displayed. In other words, in the case that number of times of use Cf of stationary blade 46 is equal to or more than stationary blade replacement requiring number of times of use Cfth, information "stationary blade replacement required" 124 is displayed every time a work start command is issued unless stationary blade holding member 48 is replaced with another stationary blade holding member 48, and even though reset switch 108 is operated, information "stationary blade replacement required" 124 is never deleted in any situation.

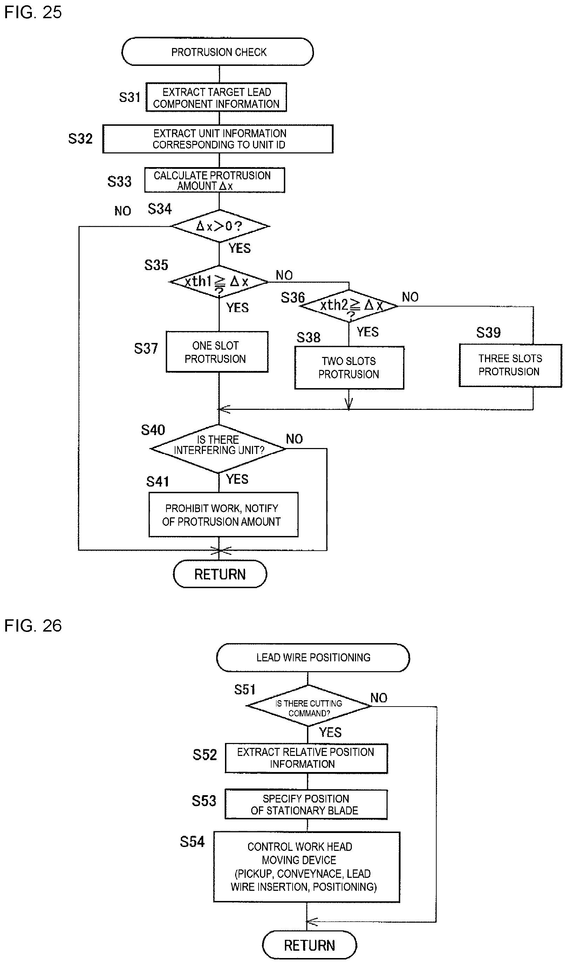

An example of a protrusion check performed in S7 will be illustrated by a routine shown in Fig. 25 The target lead component information is extracted for each of the target lead components P in S31, the unit information for unit 26 selected for target lead component P is extracted in S32, and in S33, protrusion amount Δx of target lead component P is acquired based on these target lead component information and unit information. Since target lead component P is positioned in a position where target lead wire PL comes into abutment with stationary blade 46, protrusion amount Δx can be acquired as shown in Fig. 9b from distance xa1 defined between the center point of target lead line PL of component main body PH of target lead component P and first end face FPa, diameter ϕpa of lead wire PL, width wu of through hole 60a, distance xh2 defined between the center point of through hole 60a and second side face Fsa of unit main body 36, and the like. Incidentally, in the case that diameter ϕpa of lead wire PL is very small, term (ϕpa/2) can also be regarded as 0. Δx=x1a+wu·2-xh2a-ϕpa/2

Then, it is determined in S34 whether protrusion amount Δx is greater than 0. If the determination is YES, a magnitude of protrusion amount Δx is acquired in the number of slots. In S35 and S36, it is determined whether protrusion amount Δx is equal to or less than an amount corresponding to one slot (xth1) and whether protrusion amount Δx is equal to or less than an amount corresponding to two slots (xth2), respectively. If the determination made in S35 is YES, it is determined in S37 that protrusion amount Δx corresponds one slot, while if the determination made in S35 is NO and the determination made in S36 is YES, it is determined in S38 that protrusion amount Δx corresponds to two slots, and if the determinations made in S35, S36 are both NO, it is determined in S39 that protrusion amount Δx corresponds to three slots or more.

Next, it is determined in S40 whether there exists a unit which is in interference with the target lead component. That is, it is determined whether one or more units are attached to a side of unit holding member 28 to which target lead component P protrudes. If the determination is YES, the relevant operation is prohibited in S41. Then, information "work prohibit" 120 is displayed on display 102, and information "n slots protrusion" 122 is also displayed thereon.

After the pre-work process has been performed as described heretofore, the lead wire cutting operation of mounter 1 is performed, and in the lead wire cutting operation, a positioning program, which will be illustrated by a flowchart shown in Fig. 26, is executed.

It is determined in S51 whether a lead wire cutting command has been issued for target lead component P. If the determination is YES, the relative position information for stationary blade holding member 48 of unit 26 selected for target lead component P is extracted in S52, and positions of the reference line and the reference point of through hole 60 are specified based on the position of fiducial mark 63 specified in S53 and the relative position information. In S54, work head moving device 22 is controlled based on the positions of the reference line and the reference point of through hole 60 so specified. When work head moving device 22 is so controlled, work head 20 is caused to move, whereby target lead component P held with chuck 24 is conveyed to unit 26, and target lead wire PL is inserted substantially in the center of through hole 60, whereafter target lead component P is moved in a horizontal direction to a position where target lead wire PL comes into abutment with stationary blade 46. As a result, target lead wire PL and stationary blade 46 are positioned in place. Thereafter, movable blade holding member 52 is rotated, whereby target lead wire PL is cut with stationary blade 46 and movable blade 50.

Thereafter, work head 20 is caused to move, and target lead component P is conveyed to board S, and target lead wire PL, which is cut in unit 26, is inserted into a predetermined through hole in multiple through holes formed in board S. As a result, target lead component P is mounted on board S.

The execution in S53 is executed subsequent to S3 in the pre-work process, and the positions of the reference line and the reference point of through hole 60 so specified are also allowed to be stored in memory section 100m.

After the operation of mounter 1 is started, the numbers of times of use of one or more stationary blades 46 and movable blade 50 are counted, and the history information thereof is updated. One or more stationary blades 46 and movable blade 50 get worn as a result of cutting lead wires. Due to this, when the number of times of cutting (the number of times of use) is increased, an amount of wear is increased, requiring stationary blades and movable blades to be replaced. In the present embodiment, since one or more stationary blades 46 are used equally, the numbers of times of use thereof become equal, and hence, in the following description, the numbers of times of use of one or more stationary blades 46 may be referred to simply as the number of times of use of stationary blade 46 from time to time.

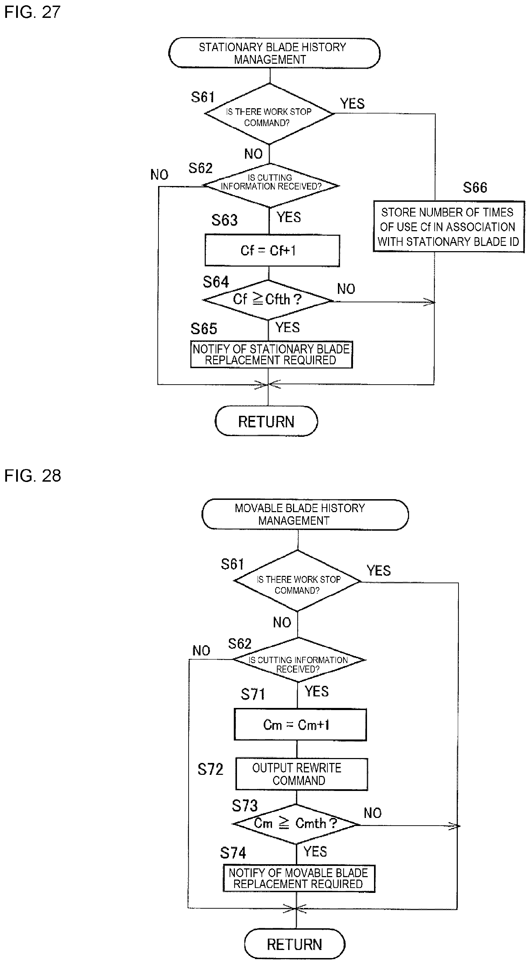

In main control device 100, a stationary blade history management program, which will be illustrated by a flowchart shown in Fig. 27, is executed for each of multiple units 26. It is determined in S61 whether a work stop command has been issued. If the determination is NO, it is determined in S62 whether cutting information supplied from unit 26 has been received. If the determination is YES, a count value of number of times of use Cf of the stationary blade, which is stored in association with the stationary blade ID, is incremented by 1 in S63, and the count value so incremented is compared with stationary blade replacement requiring number of times of use Cfth in S64. The determination in S64 continues to be NO while number of times of use Cf of stationary blade 46 remains smaller than replacement requiring number of times of use Cfth, and the operations in S61 to S64 are executed repeatedly. Then, if the number of times of use reaches or exceeds the replacement requiring number of times of use, the determination in S64 becomes YES, whereby information "stationary blade replacement required" 124 is displayed on display 102 in S65. In addition, if a work stop command is issued, the determination in S61 becomes YES, and number of times of use Cf then is stored in association with the stationary blade ID in S66.

The history management of movable blade 50 is performed for each of multiple units 26 by executing a movable blade history information management program, which will be illustrated by a flowchart shown in Fig. 28. In the movable blade history information management program, like step numbers will be appended to steps whose execution contents are like to those of the stationary blade history management program, whereby descriptions thereof will be omitted. If cutting information is received, a count value of number of times of use Cm of movable blade 50, which is stored in association with the unit ID, is counted up in S71. Then, in S72, there is outputted to tag information control section 94 a command to rewrite the information recorded in tag 92 and increment the number of times of use of movable blade 50 by one. The number of times of use of movable blade 50 recorded in tag 92 is incremented by one by tag information control section 94. It is determined in S73 whether the number of times of use of movable blade 50 is equal to or greater than movable blade replacement requiring number of times of use Cmth. If the determination is YES, information "n times of use" 128 is displayed together with information "movable blade replacement required" 126 on display 102 in S74.

In the case that a replacement of movable blade 50 is performed, and reset switch 108 is operated by the operator in a state of information "movable blade replacement required" 126 and information "n times of use" 128 being displayed, the number of times of use of movable blade 50 is reset to 0, and a command is outputted from main control device 100 to tag information control section 94, so as to rewrite the information recorded in tag 92 and set the number of times of use to 0. As a result, the number of times of use recorded in tag 92 is rewritten to 0.

Thus, as has been described heretofore, in the present embodiment, 2D code C is affixed to stationary blade holding member 48, 2D code C is imaged by camera 25 to thereby acquire the information recorded in 2D code C based on the captured image, and the information so acquired is stored in memory section 100m of main control device 100. As a result, there is provided an advantage in that the operator does not have to input information on stationary blade holding member 48 in main control device 100 every time stationary blade holding members 48 are replaced. In addition, after replacement, information on replaced stationary blade holding member 48 can easily be supplied to main control device 100, whereby the efficiency of the lead wire cutting operation can be improved.

Further, since 2D code C includes the cutting capability information of unit 26, it can be determined before the cutting operation is started whether unit 26 in question can cut a target lead wire of a target lead component. Then, in the case that it is determined that unit 26 in question cannot cut the target lead wire well, information "work prohibit" 120 is displayed, whereby a cutting failure in cutting the target lead wire can be prevented in advance, thereby making it possible to improve the efficiency.

Furthermore, since 2D code C includes the stationary blade ID, the maintenance of each of stationary blade holding members 48 can be managed individually. For example, the number of times of use of stationary blade 46 is managed individually for each of stationary blade holding members 48, and whether the stationary blade replacement requiring number of times of use is reached is determined individually, whereby whether the stationary blade replacement requiring number of times of use is reached can be determined individually. Additionally, information "stationary blade replacement required" 124 is kept displayed while a replacement of stationary blade holding members 48 does not occur. In other words, since information "stationary blade replacement required" 124 is not deleted by operating reset switch 108, the information in question can be transmitted to the operator in a more reliably.

Further, since fiducial mark 63 is provided on stationary blade holding member 48, the variation in the relative position between fiducial mark 63 and the reference point and the reference line of through hole 60 can be reduced. As a result, target lead wire PL can be inserted into through hole 60 well, whereby the accuracy with which target lead wire PL is positioned with respect to stationary blade 46 can be improved.

Furthermore, since the lead component protrusion check is performed in main control device 100, there is provided an advantage in that the operator does not have to perform the lead component protrusion check. In addition, in the case that a target lead component protrudes from unit 26 and that another unit exists on the side to which the target lead component protrudes, the start of the work is prohibited. As a result, the operator can change the attachment position of unit 26 to unit holding member 28 or the like to thereby prevent in advance an interference of the lead component with a unit lying adjacent to unit 26 in question, thereby making it possible to improve the efficiency.

Thus, as has been described heretofore, in the present embodiment, in main control device 100, a cutting determination section is configured by a section for storing S5, a section for executing S5, and the like, a unit selection section is configured by a section for storing S4, a section for executing S4, and the like, and a cutting blade management section is configured by a section for storing S6, a section for executing S6, a section for storing the stationary blade history management program shown in Fig. 27, a section for executing the program, and the like. A work prohibit section is made up of sections of the cutting determination section which include a section for storing S19, a section for executing S19, and the like. Further, a stationary blade use time counter is configured by sections of the cutting blade management section which include a section for storing S63, a section for executing S63, and the like, and a stationary blade use time memory section is configured by a section for storing the history information shown in Fig. 14 and the like of memory section 100m. Furthermore, a stationary blade replacement required notification section is made up of sections for storing S24, S65 and sections for executing s24, S65, and the like. Further, an information acquisition section and an identification information acquisition section are configured by sections of main control device 100 which include a section for storing S2, a section of a section for executing S2 which is configured to acquire the stationary blade ID, and the like. In addition, a movable blade use time counter is configured by sections of main control device 100 which include a section for storing S71, a section for executing S71, and the like, a movable blade replacement required notification section is configured by sections of main control device 100 which include a section for storing S74, a section for executing S74, and the like, and a record control section is configured by sections of main control device 100 which include a section for storing S72, a section for executing S72, tag information control section 94, and the like. Additionally, cuttable sectional area information also constitutes cuttable sectional area information by material.

A protrusion check section is configured by sections of main control device 100 such as a section for storing S7, a section for executing S7, and the like, a protrusion amount acquisition section is configured by sections of main control device 100 such as sections for storing S33, S35, S36, sections for executing S33, S35, S36, and the like, and a work prohibit section and a protrusion amount notification section as a protrusion notification section are configured by a section for storing S41, a section for executing S41, and the like. Lead component external shape information includes component side relative position information and information on a relative orientation, and the lead component external shape information corresponds to target lead component information. In addition, unit side relative position information as unit external shape information corresponds to unit information.

A position acquisition section is configured by sections of main control device 100 such as a section for storing sections for storing S3, S53 of the lead wire positioning program illustrated by the flowchart shown in Fig. 26, sections for executing S3, S53, and the like, a conveyance control section is configured by sections of main control device 100 such as a section for storing S54, a section for executing S54, and the like, and a relative position information acquiring section is configured by sections of main control device 100 such as a section for storing S2, a section for executing S2, and the like. Additionally, component insertion device 16 corresponds to a lead component conveyance device, and memory section 100m corresponds to a main memory section.

Information recorded in 2D code C is not limited to the information described in the embodiment. For example, stationary blade replacement requiring number of times of use Cfth can also be recorded in 2D code C. Additionally, when the recorded information is changed, 2D code C reflecting the change can also be affixed every time the recorded information is changed.

Further, relative position information on a relative position between fiducial mark 63 and each of the reference point and the reference line of through hole 60 can also be stored in association with the stationary blade ID in memory section 100m of main control device 100. Additionally, multiple fiducial marks 63 can also be provided. Further, the shape of the fiducial mark is not limited to the circular dot shape. For example, the fiducial mark can adopt a polygonal shape, a frame-like shape, a linear shape and the like. Additionally, fiducial mark 63 can also adopt an opening section, a projecting section, and the like.

Further, work information or the like can also be stored in a memory section provided outside main control device 100. In this case, the memory section constitutes an element making up mounter 1.

In addition, the replacement requiring number of times of use can be changed to a different number of times of use depending upon the material of a lead wire to be cut by stationary blade 46 and movable blade 50. Further, a configuration can also be adopted in which in the case that the material of a lead wire to be cut is copper, the number of times of use is incremented by one every time stationary blade 46 and movable blade 50 are used twice, while in the case that the material of a lead wire to be cut is iron or stainless steel, the number of times of use is incremented by one every time stationary blade 46 and movable blade 50 are used once. Additionally, in the case that one or more stationary blades 46 are not used equally, that is, for example, in the case that only a part of one or more stationary blades 46 is used due to the number and attachment position of target lead wire PL of target lead component P or the like, a configuration can also be adopted in which the number of times of use is counted individually for each of one or more stationary blades 46.

Further, a display of information on display 102 is not essential. The notifying device for notifying the pieces of information 120 to 128 is not limited to the display, and hence, a device for outputting voice or buzzing sound or a device for turning on and off a lamp can also be adopted for the notifying device. Further, in S41, notifying of a protrusion amount is not essential, and hence, a notification of a possibility of protrusion is good enough.

Furthermore, in the case that movable blade holding member 52 is exposed from an upper face of unit 26, a 2D code can also be provided on movable blade holding member 52 as an information recording section. A 2D code can also be provided on both stationary blade holding member 48 and movable blade holding member 52.

Further, a movable blade service life check can also be performed as a pre-work process. In this case, similar executable operations to those of the stationary blade service life check illustrated in the flowchart in Fig. 24 can be executed. The number of times of use of movable blade 50 stored in association with the unit ID recorded in tag 92 is extracted as movable blade history information.

In addition, in the embodiment that has been described heretofore, the information recorded in tag 92 is made to be rewritten every time the number of times of use of movable blade 50 is incremented; however, the number of times of use of movable blade 50 recorded in tag 92 can also be made to be rewritten when a stop command is outputted.

### Reference Signs List

18: lead wire cutting device, 24: chuck, 22: work head moving device, 25: camera, 26: lead wire cutting unit, 40: lead wire cutting mechanism, 46: stationary blade, 48: stationary blade holding member, 50: movable blade, 52: movable blade holding member, 54: driving device, 60: through hole, 62: label, 64: arm section, 65: movable member, 68: cylinder, 70: inclined member, 76: cutting switch, 90: control board, 92: tag, 100: main control device, 100m: memory section, 102: display, 104: work start switch, 106: work stop switch

## Claims

1. A mounter (1) comprising a lead wire cutting unit (26) for cutting multiple lead wires (PL) of a lead component (P), which is a component having the lead wires (PL), through a relative movement of multiple cutting blades (46,50),
wherein the multiple cutting blades (46,50) comprise one or more stationary blades (46) and one or more movable blades (50),
wherein one or more cutting blade holding members (48,52) constitute a stationary blade holding member (48) for holding the one or more stationary blades (46), the stationary blade holding member (48) being detachably attached to the lead wire cutting unit (26), at a peripheral portion thereof,
wherein the stationary blade holding member (48) comprises one or more through holes (60) at least a part of an edge of which is functioning as the stationary blade (46), and
wherein the mounter (1) further comprises an imaging device (25) and is configured to mount the lead component (P) in which the multiple lead wires (PL) are cut by the lead wire cutting unit (26) on a circuit board,
**characterized in that**
the lead wire cutting unit (26) is provided with at least one fiducial mark (63) which is provided on the stationary blade holding member (48), in which the at least one fiducial mark (63) resides at a predetermined relative position with each of the one or more stationary blades (46),
the relative position is a relative position between each of the at least one fiducial mark and each of reference points or reference lines of the one or more through holes (60), and
the mounter (1) further comprises a main memory section (100m) storing relative position information, indicating the relative position relationship between each of the at least one fiducial mark (46) and the one or more stationary blades (46), and a cutting blade position acquisition section configured to acquire a position of each of the at least one fiducial mark (63) based on a captured image of the at least one fiducial mark (63) captured by the imaging device (25), and thereby acquire a position of each of the one or more stationary blades (46) with respect to the at least one fiducial mark (63) based on the position of each of the at least one fiducial mark (63) so acquired and the relative position information stored in the main memory section (100m).

2. The mounter (1) according to claim 1,
wherein a relative position information record section (62) is provided on the stationary blade holding member (48), and records a relative position information which constitutes information indicating the relative position between each of the one or more stationary blades (46) and each of the at least one fiducial mark (63).

3. The mounter (1) according to claim 2,
wherein the relative position information record section (62) constitutes a two-dimensional code (C), and
wherein a label (62) on which the two-dimensional code (C) is printed is affixed to the stationary blade holding member (48).

4. The mounter (1) according to any one of claims 1 to 3,
wherein the mounter (1) comprises a lead component conveyance device (16) configured to convey the lead component (P) from a component supply device (14) to a position where the multiple lead wires (PL) come into abutment with the one or more stationary blades (46) of the lead wire cutting unit (26) and a conveyance control section configured to control the lead component conveyance device (16) based on positions of the one or more stationary blades (46) acquired by the cutting blade position acquisition section.

5. The mounter (1) according to at least both claims 2 and 4,
wherein the lead component conveyance device (16) comprises the imaging device,
wherein a relative position information record section (62) is provided on the stationary blade holding member (48), and records a relative position information constituting information indicating the relative position between each of the one or more stationary blades (46) and each of the at least one fiducial mark (63), and
wherein the mounter (1) comprises a relative position information acquiring section configured to acquire the relative position information based on a captured image of the relative position information record section (62) captured by the imaging device to thereby store the relative position information so acquired in the main memory section (100m).

## Patentansprüche

1. Eine Montagevorrichtung (1) mit einer Anschlussdraht-Schneideeinheit (26) zum Schneiden mehrerer Anschlussdrähte (PL) einer Anschlusskomponente (P), die eine Komponente mit Anschlussdrähten (PL) ist, durch eine relative Bewegung mehrerer Schneidklingen (46, 50),
wobei die mehreren Schneidklingen (46, 50) eine oder mehrere stationäre Klingen (46) und eine oder mehrere bewegliche Klingen (50) umfassen,
wobei ein oder mehrere Schneidklingen-Halteelemente (48, 52) ein stationäres Klingenhalteelement (48) zum Halten der einen oder mehreren stationären Klingen (46) bilden, wobei das stationäre Klingen-Halteelement (48) abnehmbar an der Anschlussdraht-Schneideinheit (26) an einem Umfangsabschnitt davon befestigt ist,
wobei das stationäre Klingenhalteelement (48) ein oder mehrere Durchgangslöcher (60) aufweist, von denen zumindest ein Teil einer Kante als die stationäre Klinge (46) fungiert, und
wobei die Montagevorrichtung (1) ferner eine Abbildungsvorrichtung (25) umfasst und so konfiguriert ist, dass sie die Anschlusskomponente (P), in der die mehreren Anschlussdrähte (PL) durch die Anschlussdraht-Schneideeinheit (26) geschnitten werden, auf einer Leiterplatte montiert,
**gekennzeichnet dadurch, dass**
die Anschlussdraht-Schneideeinheit (26) mit mindestens einer Bezugsmarke (63) versehen ist, die auf dem stationären Klingenhalteelement (48) angeordnet ist, wobei sich die mindestens eine Bezugsmarke (63) in einer vorbestimmten Relativposition zu jeder der einen oder mehreren stationären Klingen (46) befindet,
die Relativposition eine Relativposition zwischen jeder der mindestens einen Bezugsmarke und jedem von Referenzpunkten oder Referenzlinien des einen oder der mehreren Durchgangslöcher (60) ist, und
die Montagevorrichtung (1) ferner einen Hauptspeicherabschnitt (100m), der Relativpositionsinformationen speichert, die die Relativpositionsbeziehung zwischen jeder der mindestens einen Bezugsmarke (46) und der einen oder mehreren stationären Klingen (46) angeben, und einen Schneidklingenpositionserfassungsabschnitt umfasst, der konfiguriert ist, eine Position jeder der mindestens einen Bezugsmarke (63) auf der Grundlage eines erfassten Bildes der mindestens einen Bezugsmarke (63), das von der Abbildungsvorrichtung (25) erfasst wurde, zu erfassen und dadurch eine Position jeder der einen oder mehreren stationären Klingen (46) in Bezug auf die mindestens eine Bezugsmarke (63) auf der Grundlage der Position jeder der mindestens einen so erfassten Bezugsmarke (63) und der in dem Hauptspeicherabschnitt (100m) gespeicherten relativen Positionsinformationen zu erfassen.

2. Die Montagevorrichtung (1) gemäß Anspruch 1, wobei
ein Relativpositionsinformationsaufzeichnungsabschnitt (62) an dem stationären Klingenhalteelement (48) angeordnet ist und eine Relativpositionsinformation aufzeichnet, die eine Information darstellt, die die Relativposition zwischen jeder der einen oder mehreren stationären Klingen (46) und jeder der mindestens einen Bezugsmarke (63) angibt.

3. Die Montagevorrichtung (1) gemäß Anspruch 2, wobei
der Relativpositionsinformationsaufzeichnungsabschnitt (62) einen zweidimensionalen Code (C) bildet, und wobei
ein Etikett (62), auf dem der zweidimensionale Code (C) aufgedruckt ist, an dem stationären Klingenhalteelement (48) befestigt ist.

4. Die Montagevorrichtung (1) gemäß einem der Ansprüche 1 bis 3, wobei
die Montagevorrichtung (1) eine Anschlusskomponenten-Fördervorrichtung (16) umfasst, die konfiguriert ist, die Anschlusskomponente (P) von einer Komponentenzuführungsvorrichtung (14) zu einer Position zu befördern, in der die mehreren Anschlussdrähte (PL) mit der einen oder den mehreren stationären Klingen (46) der Anschlussdraht-Schneideeinheit (26) in Berührung kommen, und einen Fördersteuerungsabschnitt umfasst, der konfiguriert ist, die Anschlusskomponenten-Fördervorrichtung (16) auf der Grundlage von Positionen der einen oder der mehreren stationären Klingen (46) zu steuern, die von dem Schneidklingenpositionserfassungsabschnitt erfasst werden.

5. Die Montagevorrichtung (1) gemäß einem der Ansprüche 2 bis 4, wobei
die Anschlusskomponenten-Fördervorrichtung (16) die Abbildungsvorrichtung umfasst, wobei
ein Relativpositionsinformationsaufzeichnungsabschnitt (62) an dem stationären Klingenhalteelement (48) angeordnet ist und eine Relativpositionsinformation aufzeichnet, die eine Information darstellt, die die Relativposition zwischen jeder der einen oder mehreren stationären Klingen (46) und jeder der mindestens einen Bezugsmarke (63) angibt, und wobei
die Montagevorrichtung (1) einen Relativpositionsinformations-Erfassungsabschnitt umfasst, der konfiguriert ist, die Relativpositionsinformationen auf der Grundlage eines erfassten Bildes des Relativpositionsinformations-Aufzeichnungsabschnitts (62), das von der Abbildungsvorrichtung erfasst wird, erfasst, um dadurch die so erfassten Relativpositionsinformationen in dem Hauptspeicherabschnitt (100m) zu speichern.

## Revendications

1. Appareil de montage (1) comprenant une unité de coupe de fil conducteur (26) pour couper plusieurs fils conducteurs (PL) d'un composant conducteur (P), qui est un composant ayant les fils conducteurs (PL), par un mouvement relatif de multiples lames de coupe (46, 50),
dans lequel les multiples lames de coupe (46, 50) comprennent une ou plusieurs lames fixes (46) et une ou plusieurs lames mobiles (50),
dans lequel un ou plusieurs éléments de maintien de lame de coupe (48, 52) constituent un élément de maintien de la lame fixe (48) pour maintenir une ou plusieurs lames fixes (46), l'élément de maintien de la lame fixe (48) étant fixé de manière amovible à l'unité de coupe de fil conducteur (26), au niveau d'une partie périphérique de celle-ci,
dans lequel l'élément de maintien de la lame fixe (48) comprend un ou plusieurs trous traversants (60) dont au moins une partie d'un bord fonctionne comme la lame fixe (46), et
dans lequel l'appareil de montage (1) comprend en outre un dispositif d'imagerie (25) et est configuré pour monter le composant conducteur (P) dans lequel les plusieurs fils conducteurs (PL) sont coupés par l'unité de coupe de fil conducteur (26) sur une carte de circuit imprimé,
**caractérisé en ce que**
l'unité de coupe de fil conducteur (26) est pourvue d'au moins une marque fiduciaire (63) située sur l'élément de maintien de la lame fixe (48), dans laquelle l'au moins une marque fiduciaire (63) se trouve à une position relative prédéterminée par rapport à chacune ou des une ou plusieurs lames fixes (46),
la position relative est une position relative entre chacune des au moins une marque fiduciaire et chacun·e des points de référence ou des lignes de référence des un ou plusieurs trous traversants (60), et
l'appareil de montage (1) comprend en outre une section de mémoire principale (100 m) stockant des informations de position relative, indiquant la relation de position relative entre chacune des au moins une marque fiduciaire (46) et une ou plusieurs lames fixes (46), et une section d'acquisition de position de lame de coupe configurée pour acquérir une position de chacune des au moins une marque fiduciaire (63) sur la base d'une image capturée de l'au moins une marque fiduciaire (63) capturée par le dispositif d'imagerie (25), et
acquérir ainsi une position de chacune des une ou plusieurs lames fixes (46) par rapport à l'au moins une marque fiduciaire (63) sur la base de la position de chacune de l'au moins une marque fiduciaire (63) ainsi acquise et des informations de position relative stockées dans la section de mémoire principale (100 m).

2. Appareil de montage (1) selon la revendication 1,
dans lequel une section d'enregistrement des informations de position relative (62) est prévue sur l'élément de maintien de la lame fixe (48), et enregistre des informations de position relative qui constituent des informations indiquant la position relative entre chacune des une ou plusieurs lames fixes (46) et chacun des au moins une marque fiduciaire (63).

3. Appareil de montage (1) selon la revendication 2,
dans lequel la section d'enregistrement des informations de position relative (62) constitue un code bidimensionnel (C), et
dans lequel une étiquette (62) sur laquelle le code bidimensionnel (C) est imprimé est fixée à l'élément de maintien de la lame fixe (48).

4. Appareil de montage (1) selon l'une quelconque des revendications 1 à 3,
dans lequel l'appareil de montage (1) comprend un dispositif de transport de composant conducteur (16) configuré pour transporter le composant conducteur (P) depuis un dispositif d'approvisionnement en composants (14) jusqu'à une position où les plusieurs fils conducteurs (PL) entrent en contact avec les une ou plusieurs lames fixes (46) de l'unité de coupe de fil conducteur (26) et une section de commande du transport configurée pour commander le dispositif de transport de composant conducteur (16) sur la base des positions des une ou plusieurs lames fixes (46) acquises par la section d'acquisition de position de lame de coupe.

5. Appareil de montage (1) selon au moins les deux revendications 2 et 4,
dans lequel le dispositif de transport de composant conducteur (16) comprend le dispositif d'imagerie,
dans lequel une section d'enregistrement des informations de position relative (62) est prévue sur l'élément de maintien de la lame fixe (48), et enregistre des informations de position relative constituant des informations indiquant la position relative entre chacune des une ou plusieurs lames fixes (46) et chacun des au moins une marque fiduciaire (63), et
dans lequel l'appareil de montage (1) comprend une section d'acquisition des informations de position relative configurée pour acquérir les informations de position relative sur la base d'une image capturée de la section d'enregistrement des informations de position relative (62) capturée par le dispositif d'imagerie, afin de stocker les informations de position relative ainsi acquises dans la section de mémoire principale (100 m).
